# EUROPEAN PATENT APPLICATION

(11) **EP 1 065 696 A2**
(43) Date of publication of application: **03.01.2001**
(21) Application number: 00305203.2
(22) Date of filing: 20.06.2000
(51) Int. Cl.: H01J 37/08, H01J 37/317

(54) **Ion implantation apparatus and ion source and ion source subassembly for use in ion implantation apparatus**

(30) Priority: 29.06.1999 US 342783
(71) Applicant: LUCENT TECHNOLOGIES INC., Murray Hill, New Jersey 07974-0636 (US)
(72) Inventor: Johnson, Otis, Jr., Orlando, FL 32765 (US); Obeng, Yaw Samuel, Orlando, FL 32824 (US)
(74) Representative: Watts, Christopher Malcolm Kelway, Dr.

(57) **Abstract**

An ion source for use in an ion implantation apparatus, the ion source comprising
a cathode, a filament, a filament support assembly, and a support member. The filament support assembly positions the filament within the cathode. The support member is configured to maintain the filament within the cathode at a desired position during operation of the ion source and when there is a loosening of a grip that the filament support assembly has on the filament.

## Description

### Field Of The Invention

The present invention relates to an ion implantation apparatus, and more particularly, to an ion source and ion source subassembly for use in an ion implantation apparatus.

### Description Of The Related Art

When fabricating semiconductor integrated circuit devices, it is often desirable to dope a semiconductor substrate or wafer with impurities to produce doped regions, such as well regions, channel regions, or source or drain regions. Such doping can be accomplished using ion implantation technologies. For this purpose, semiconductor processing facilities typically include an ion implantation apparatus.

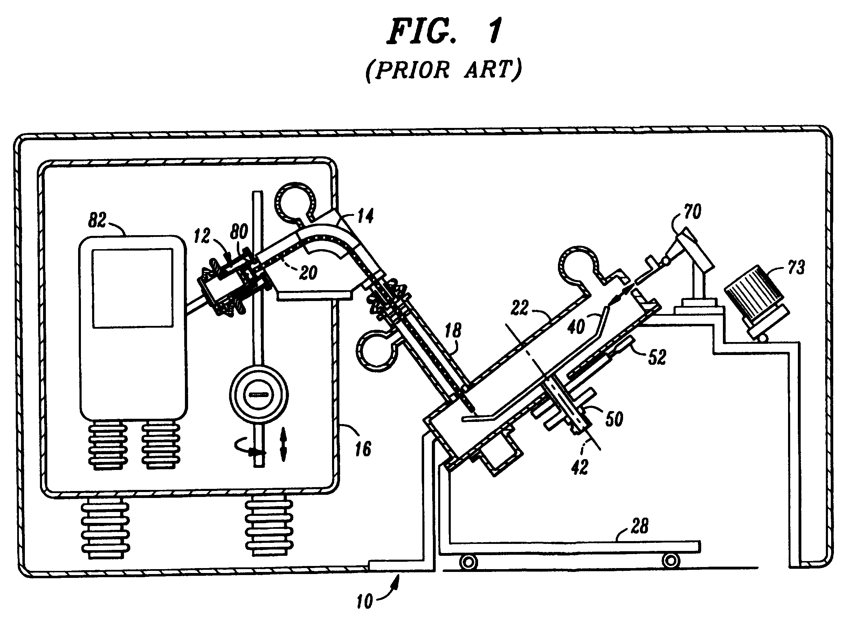

One example of an ion implantation apparatus is described in U.S. Patent No. 5,497,006 to Sferlazzo et al., which is incorporated herein by reference. The ion implantation apparatus of Sferlazzo et al. and its various components are reproduced in Figs. 1-5. As shown in Fig. 1, the ion implantation apparatus 10 comprises, among other things, an ion source 12 and a beam analyzing magnet 14 supported by a high voltage housing 16. Ions produced by the ion source 12 are accelerated away from the ion source 12 by electric fields produced by extraction electrodes 80. An ion beam 20 exiting the ion source 12 travels through an evacuated tube 18 and enters an ion implantation chamber 22 where it impinges upon one or more targets, e.g., silicon wafers, supported by a support 40. While traveling from the ion source 12 to the ion implantation chamber 22, the ion beam 20 is shaped, evaluated, and accelerated to a desired implantation energy. The ion beam analyzing magnet 14, which is controlled by an implanter controller 82, causes only those ions having an appropriate mass to reach the ion implantation chamber 22 by producing a magnetic field that bends the trajectory of those ions to an implant trajectory.

Silicon wafers are inserted into the ion implantation chamber 22 by a robotic arm 70 from a cassette 73. The ion implantation chamber 22 is supported on a movable pedestal 28 that allows the ion implantation chamber 22 to be aligned relative to the ion beam 20. A motor 50 rotates the support 40 about an axis 42 and a linear drive 52 indexes the support 40 back and forth within the chamber 22. The support 10 is positioned such that untreated wafers can be moved into the chamber 22 and treated wafers can be withdrawn from the chamber 22 by the robotic arm 70.

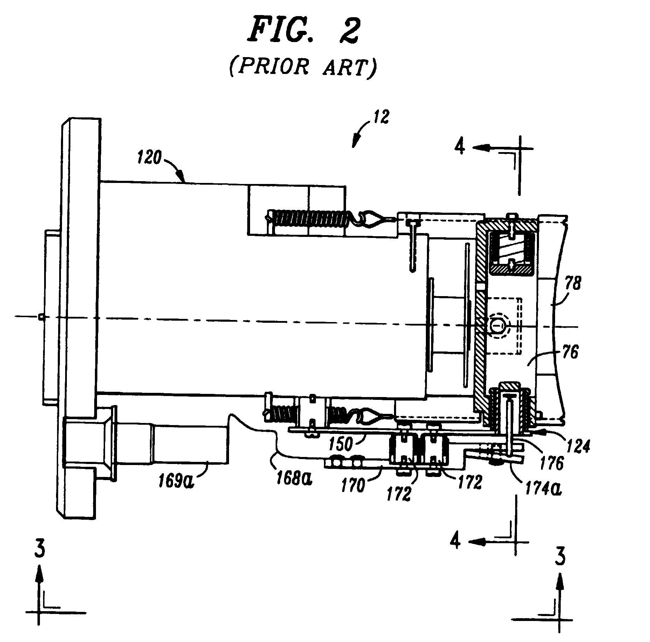

As shown in Figs. 2-5, the ion source 12 comprises, among other things, a plasma arc chamber 76 having an exit aperture 78, a support block 120 that supports the plasma arc chamber 76, and a cathode 124. The plasma arc chamber 76 has conductive walls that define a space in which electrons emitted from the cathode 124 engage gas molecules to generate ions. The ions migrate through the opening 78 and are accelerated by the extraction electrodes 80 (Fig. 1).

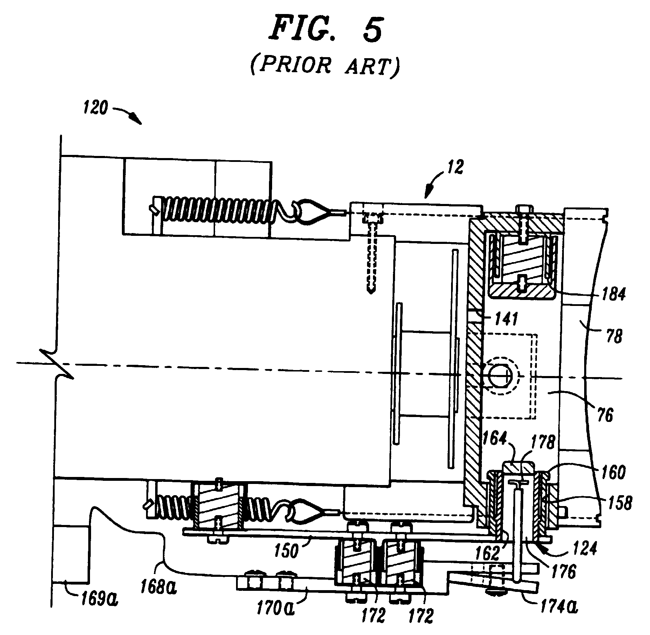

The plasma arc chamber 76 has a surface defining an opening 158 (Fig. 5) in its lower end. The cathode 124 protrudes through the opening 158 and extends into an interior of the plasma arc chamber 76 without touching the chamber walls that define the opening 158. A mounting plate 150, which is attached to but electrically isolated from the support block 120, supports the cathode 124. The cathode 124 comprises an outer tubular member 160 made from a molybdenum alloy material, an inner tubular member 162 that is also made from a molybdenum alloy material, and a conductive cap 164 made from a tungsten material.

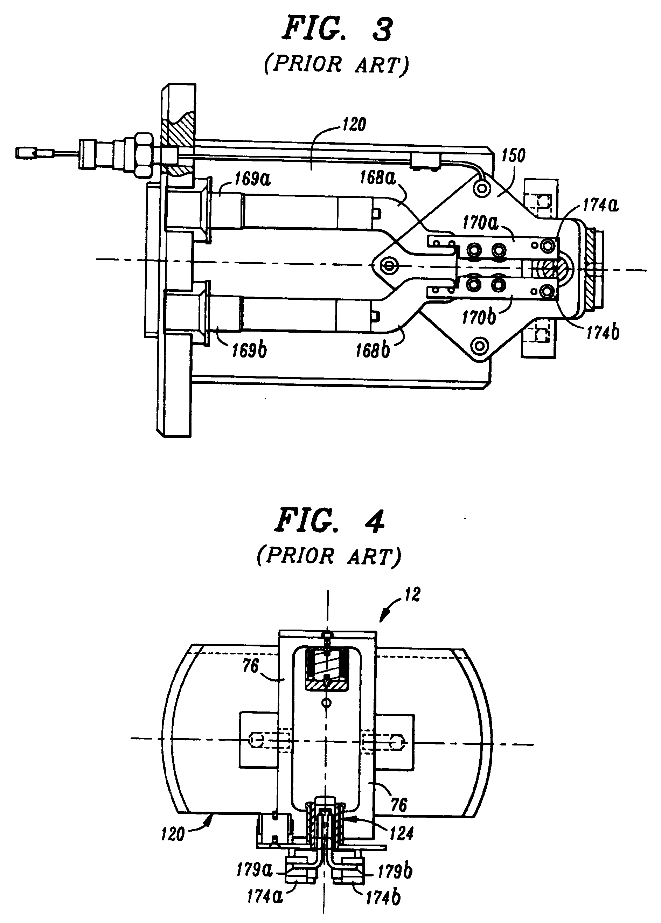

Two conductive mounting arms 170a and 170b comprising, for example, molybdenum support a tungsten filament 178 (Fig. 5) inside the cathode 124. The mounting arms 170a and 170b are mounted in spaced relation to the mounting plate 150 by insulators 172 and are coupled to power feed throughs 169a and 169b via conductive filament energizing bands 168a and 168b. The filament 178 is fixed within a cavity 176 defined by the innermost tubular member 162 by clamps 174a and 174b, which comprise, for example, molybdenum. First and second tantalum legs 179a and 179b (FIG. 4) support the ends of the filament 178. The first and second tantalum legs 179a and 179b are held in electrical contact with the arms 170a and 170b by the clamps 174a and 174b.

When the filament 178 is energized by application of a potential difference across the feed throughs 169a and 169b, the filament 178 emits electrons, which accelerate toward and impact the cap 164. When the cap 164 is sufficiently heated by electron bombardment, it in turn emits electrons into the plasma arc chamber 76. These electrons strike gas molecules and create ions within the plasma arc chamber 76. An ion plasma is created and ions within this plasma exit the opening 78 to form the ion beam 20.

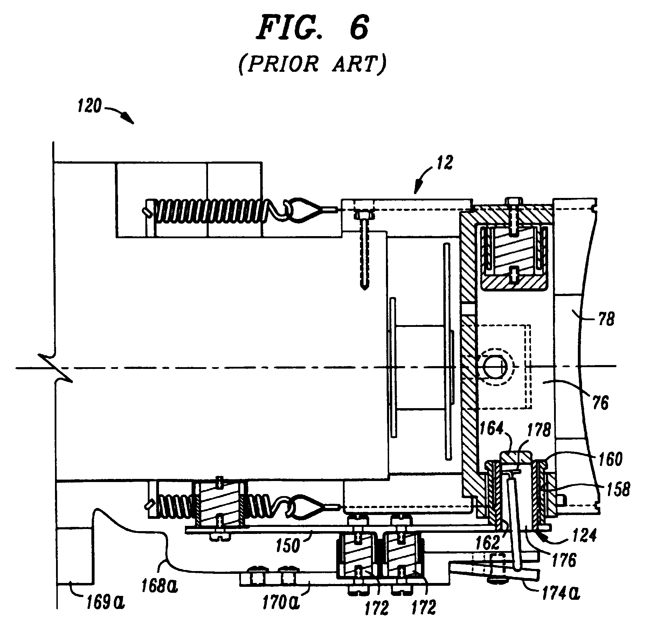

One problem with the design of the ion source 12 is that when it is operated at a high rate, i.e., at full power, the filament 178 and the cathode 124 can become misaligned and may short. In particular, at high temperatures (e.g., about 3000-4000°C), differences in the coefficients of thermal expansion of the legs 179a and 179b and the coefficients of thermal expansion of the clamps 174a and 174b and/or the arms 170a and 170b cause a mismatch between the dimensions of the components. This mismatch results in a loosening of the grip that the clamps 174a and 174b and the arms 170a and 170b have on the legs 179a and 179b leading to displacement of the filament 178 from its desired position. As shown in Fig. 6, in cases where the displacement is sufficiently large, the filament 178 shorts to the cathode 124 causing a loss of current and interruption of the ion creation process. As a result, the efficiency of the ion implantation apparatus is severely reduced.

### Summary Of The Invention

Accordingly, the present invention is directed to ion implantation apparatus and an ion source and ion source subassembly for use in an ion implantation apparatus that substantially obviate one or more of the problems due to limitations and disadvantages of the related art.

Additional features and advantages of the invention will be set forth in the description that follows and, in part, will be apparent from the description, or may be learned by practice of the invention. The objectives and other advantages of the invention will be realized and attained by the ion implantation apparatus, ion source, and ion source subassembly particularly pointed out in the written description and claims hereof as well as the appended drawings.

To achieve these and other advantages and in accordance with the purposes of the invention, as embodied and broadly described, the invention provides an ion source for use in an ion implantation apparatus, the ion source comprising a cathode, a filament, a filament support assembly, and a support member. The filament support assembly positions the filament within the cathode. The support member is configured to maintain the filament within the cathode at a desired position during operation of the ion source and when there is a loosening of a grip that the filament support assembly has on the filament.

To further achieve these and other advantages and in accordance with the purposes of the invention, as embodied and broadly described, the invention also provides an ion implantation apparatus comprising an ion source, and an ion beam analyzing magnet for directing ions produced by the ion source towards an ion implantation chamber. The ion source comprises a cathode, a filament, a filament support assembly, the filament support assembly positioning the filament within the cathode, and a support member, the support member being configured to maintain the filament within the cathode at a desired position during operation of the ion source and when there is a loosening of a grip that the filament support assembly has on the filament.

To still further achieve these and other advantages and in accordance with the purpose of the invention, as embodied and broadly described, the invention also provides an ion source subassembly for use in an ion source of an ion implantation apparatus. The ion source includes a cathode and a filament support assembly for positioning a filament within the cathode. The ion source subassembly comprises a filament and a support member. The support member is configured to maintain the filament within the cathode at a desired position during operation of the ion source and when there is a loosening of a grip that the filament support assembly has on the filament.

It is to be understood that both the foregoing general description and the following detailed description are exemplary and explanatory and are intended to provide further explanation of the invention as claimed.

### Brief Description Of The Drawings

The accompanying drawings, which are included to provide a further understanding of the invention and are incorporated in and constitute a part of this specification, illustrate several embodiments of the invention and, together with the written description, serve to explain the principles of the invention. In the drawings:
Fig. 1 is schematic view of a conventional ion implantation apparatus;
Fig. 2 is a partial cross-sectional view of an ion source of the ion implantation apparatus of Fig. 1;
Fig. 3 is a bottom elevation view of the ion source of Fig. 2, as seen from the plane 3―3 in Fig. 2;
Fig. 4 is a partially sectioned view of the ion source of Fig. 2, as seen from the plane 4―4 of Fig. 2;
Fig. 5 is an enlarged cross-sectional view of a portion of the ion source of Fig. 2;
Fig. 6 is an enlarged cross-sectional view of a portion of the ion source of Fig. 2 showing a shorting of the filament and the cathode;
Fig. 7 is an enlarged cross-sectional view of a portion of an ion source according to the present invention;
Fig. 8 is a bottom elevation view of the ion source of Fig. 7, as seen from the plane 5―5 in Fig. 7;
Figs. 9A-9C are a perspective view, side view, and bottom view, respectively, of a support member according to the present invention; and
Fig. 10 is a perspective view of an ion source subassembly according to the present invention.

### Description Of The Preferred Embodiments

Reference will now be made in detail to the presently preferred embodiments of the invention, examples of which are illustrated in the accompanying drawings.

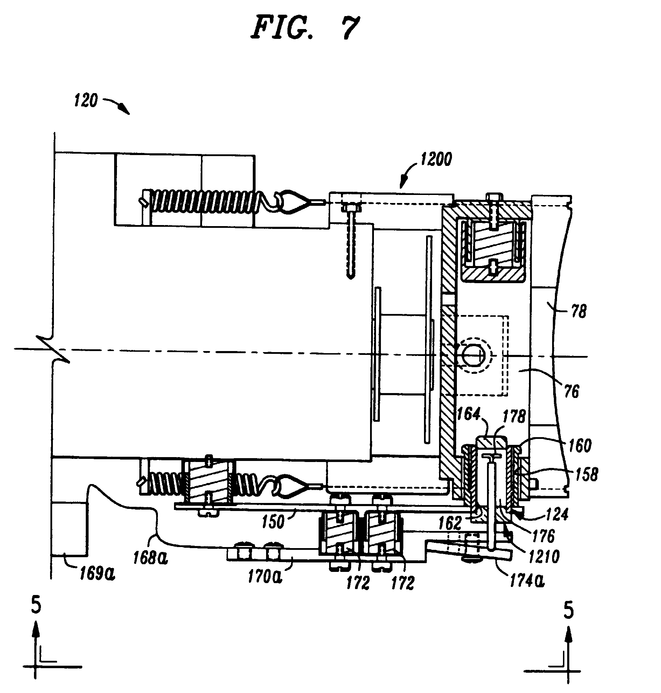

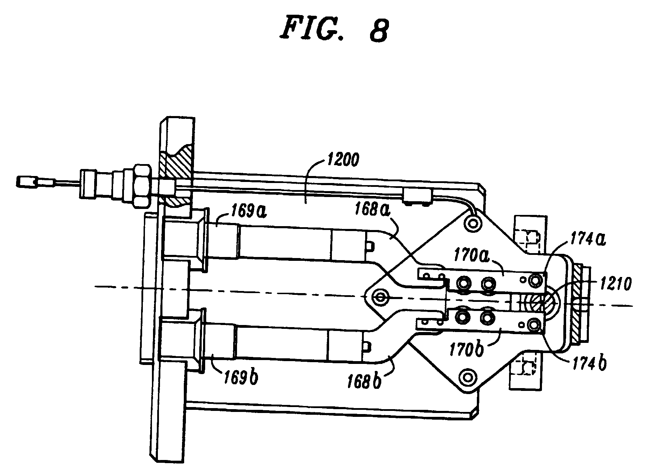

An ion source according to the present invention is shown in Figs. 7 and 8 and is designated generally by reference numeral 1200. It should be appreciated that the ion source 1200 is similar to the ion source 12 of Figs. 1-6 except for the addition of a support member 1210. As embodied herein, the support member 1210 is configured (i.e., shaped and sized) to maintain the filament 178 within the cathode 124 at a desired position during operation of the ion source 12, even in situations where there is a loosening of the grip that the clamps 174a and 174b and the arms 170a and 170b have on the legs 179a and 179b. Accordingly, the support member 1210 prevents shorting of the filament 178 and the cathode 124 in those situations. Moreover, the support member 1210 facilitates assembly (both initial assembly and rebuilding) of the ion source 1200 by ensuring proper alignment of the filament 178 within the cathode 124.

The support member 1210 is preferably mounted on and supported by the mounting plate 150. The support member 1210 also preferably comprises a material that is electrically non-conducting and can withstand temperatures in excess of those generated during operation of the ion source 1200 (e.g., temperatures in excess of 3000°C). One such material is Boron Nitride. Further, the coefficient of thermal expansion of the support member 1210 is preferably substantially within the range of the coefficients of thermal expansion of the cathode 124 and the filament 178 to avoid stress to the components that could result in the premature failure of the ion source 1200.

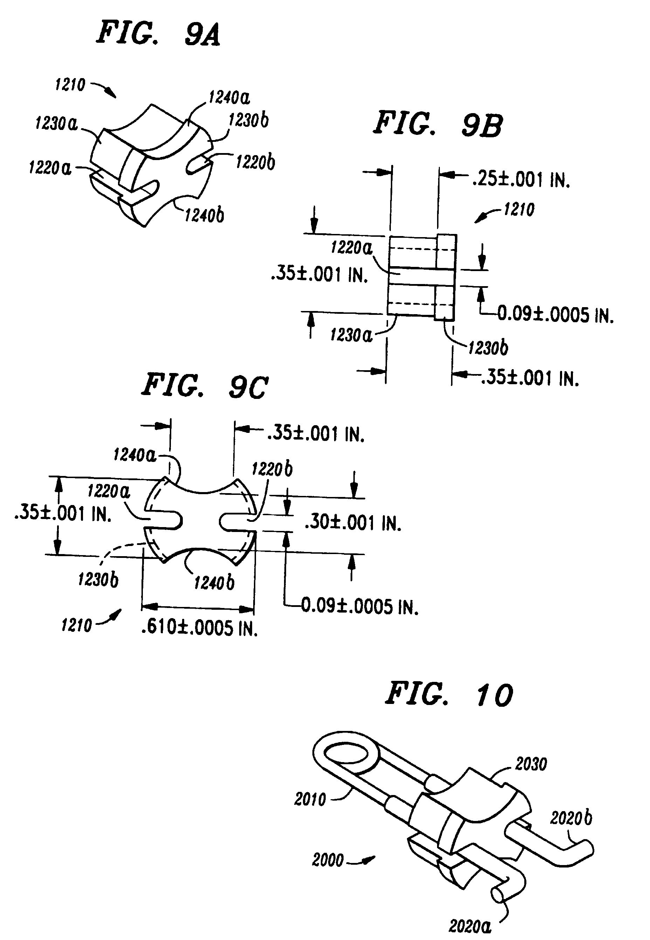

Figs. 9A-9C illustrate one embodiment of the support member 1210 with exemplary dimensions. As shown in Figs. 9A-9C, the support member 1210 includes an upper portion 1230a that is configured to fit snugly within the cavity 176 and a flanged bottom portion 1230b that is configured to act as a stopper when the support member 1210 is inserted into the cavity 176 during assembly of the ion source 1200. The support member 1210 further includes first and second grooves 1220a and 1220b and first and second cutouts 1240a and 1240b. The first and second grooves 1220a and 1220b are configured to receive the legs 179a and 179b. The first and second cutouts 1240a and 1240b are configured to allow for air flow around the support member 1210, which helps to transfer heat from the support member 120 during operation. The first and second cutouts 1220a and 1220b are also configured to ensure a proper fit of the support member 1210 within the cavity 176 and to improve the structural integrity of the support member 1210. It should be appreciated that the support member 1210 can have any number of alternative configurations so long as it maintains the filament 178 within the cathode 124 at a desired position during operation of the ion source 1200, even in situations where there is a loosening of the grip that the clamps 174a and 174b and the arms 170a and 170b have on the legs 179a and 179b.

Fig. 10 illustrates an ion source subassembly 2000 according to the present invention for use in an ion source of an ion implantation apparatus. As shown in Fig. 10, the ion source subassembly 2000 comprises a filament 2010 and a support member 2030. The ion source subassembly 200 optionally further includes first and second conductive legs 2020a and 2020b, that support the ends of the filament 2010.

The ion source subassembly 2000 is supported in position within the cathode of an ion source by a filament support assembly (not shown), such as the mounting arms 170a and 170 and the clamps 174a and 174b of Figs. 1-8. As is the case with the support member 1210 of Figs. 7, 8 and 9A-9C, the support member 2030 of Fig. 10 is configured to maintain the filament 2010 within the cathode at a desired position during operation of the ion source, even in situations where there is a loosening of the grip that the filament support assembly has on the filament 2010. Again, such loosening can come about, for example, when the ion source is operated at high temperatures and differences in the coefficient of thermal expansion of the filament 2010 (or the legs 2020a and 2020b when included) and the coefficient of thermal expansion of the filament support assembly cause a mismatch between the dimensions of the components. Accordingly, the support member 2030 reduces the risk that the filament 2010 will short the cathode. Moreover, the support member 2030 facilitates the assembly (both initial assembly and rebuilding) of the ion source by ensuring proper alignment of the filament 2010 within the cathode.

It should be appreciated that the ion source subassembly 2000 can be used with any number of ion sources, including, but not limited to the ion sources 12 and 1200 illustrated in Figs. 1-8, that include a filament positioned within a cathode by a filament support assembly. It should also be appreciated that such a filament support assembly can take any number of forms, including, but not limited to the mounting arms 170a and 170b and the clamps 174a and 174b of Figs. 1-8.

It will be apparent to those skilled in the art that various modifications and variations can be made to the ion implantation apparatus, ion source, and ion source subassembly of the present invention without departing from the scope of the invention. Thus, it is intended that the present invention covers the modifications and variations of this invention provided they come within the scope of the appended claims.

## Claims

1. An ion source for use in an ion implantation apparatus, the ion source comprising:
a cathode;
a filament;
a filament support assembly, the filament support assembly positioning the filament within the cathode; and
a support member, the support member being configured to maintain the filament within the cathode at a desired position during operation of the ion source and when there is a loosening of a grip that the filament support assembly has on the filament.

2. The ion source of claim 1, wherein the filament and the filament support assembly have different coefficients of thermal expansion which results in the loosening of the grip that the filament support assembly has on the filament during operation of the ion source.

3. The ion source of claim 1, further comprising first and second conductive legs supporting ends of the filament.

4. The ion source of claim 3, wherein the filament comprises tungsten, the first and second conductive legs comprise tantalum, and the filament support assembly comprises molybdenum.

5. The ion source of claim 1, wherein the support member comprises Boron Nitride.

6. The ion source of claim 1, wherein the support member is electrically non-conducting.

7. The ion source of claim 1, wherein the support member can withstand temperatures in excess of those generated by the ion source during operation of the ion source.

8. The ion source of claim 7, wherein the support member can withstand temperatures in excess of 3000°C.

9. The ion source of claim 1, wherein a coefficient of thermal expansion of the support member is within a range of coefficients of thermal expansion of the cathode and the filament.

10. The ion source of claim 1, wherein the support member includes first and second grooves configured to receive the filament.

11. The ion source of claim 1, wherein the support member is configured to fit within the cathode.

12. The ion source of claim 1, wherein the support member includes an upper portion that is configured to fit within the cathode and a flanged bottom portion that is configured to act as a stopper when the support member is inserted into the cavity during assembly of the ion source.

13. The ion source of claim 1, wherein the filament support assembly includes first and second clamps and first and second support arms, respective ends of the filament being fixed between respective ones of the first and second clamps and the first and second support arms.

14. An ion implantation apparatus comprising:
an ion source; and
an ion beam analyzing magnet for directing ions produced by the ion source towards an ion implantation chamber, the ion source comprising,
a cathode,
a filament,
a filament support assembly, the filament support assembly positioning the filament within the cathode, and
a support member, the support member being configured to maintain the filament within the cathode at a desired position during operation of the ion source and when there is a loosening of a grip that the filament support assembly has on the filament.

15. An ion source subassembly for use in an ion source of an ion implantation apparatus, the ion source including a cathode and a filament support assembly for positioning a filament within the cathode, the ion source subassembly comprising:
a filament; and
a support member, the support member being configured to maintain the filament within the cathode at a desired position during operation of the ion source and when there is a loosening of a grip that the filament support assembly has on the

16. The ion source subassembly of claim 15, wherein the filament support assembly includes first and second clamps and first and second support arms, respective ends of the filament being fixed between respective ones of the first and second clamps and the first and second support arms.
